# EUROPEAN PATENT APPLICATION

(11) **EP 0 979 883 A1**
(43) Date of publication of application: **16.02.2000**
(21) Application number: 98950467.5
(22) Date of filing: 30.10.1998
(51) Int. Cl.: C30B 29/40, C30B 29/48, C30B 11/12

(54) **PROCESS FOR THE PREPARATION OF SINGLE CRYSTALS OF COMPOUND SEMICONDUCTORS, EQUIPMENT THEREFOR, AND SINGLE CRYSTALS OF COMPOUND SEMICONDUCTORS**

(30) Priority: 25.12.1997 JP 35816397; 25.12.1997 JP 35817897; 08.01.1998 JP 212498; 08.01.1998 JP 212598; 09.07.1998 JP 19421698
(71) Applicant: JAPAN ENERGY CORPORATION, Tokyo 105-0001 (JP)
(72) Inventor: ODA, Osamu, Japan Energy Corp., Toda-shi, Saitama 335-8502 (JP); SEKI, Youji, Japan Energy Corp., Toda-shi, Saitama 335-8502 (JP); INOUE, Takayuki, Japan Energy Corp., Toda-shi, Saitama 335-8502 (JP)
(74) Representative: Rackham, Stephen Neil
(86) International application number: JP9804924
(87) International publication number: WO9934037

(57) **Abstract**

An object is to provide a novel process for producing a compound semiconductor single crystal, a novel apparatus therefor or the like, which can grow the single crystal having enough size by using the material in which the decomposition pressure of the component element of the compound semiconductor is over 100 atm. The process for producing compound semiconductor single crystal, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises the steps of: (1) introducing a container for growing crystals, in which a predetermined amount of the element M is put and the gas including the element X into a predetermined treatment chamber having a heating member and a pressurizing member; (2) heating the element M in the container for growing crystals to a predetermined temperature by the heating member to melt the element M; (3) applying a predetermined pressure to the gas including the element X by the pressurizing member to solve the gas in the melt of the element M; and (4) further increasing a pressure of the gas including the element X by the pressurizing member while a temperature of the melt of the element M, in which the gas including the element X is solved is kept constant, and controlling the heating member and the pressurizing member so that conditions of a temperature and of a pressure can be in a stable domain as a solid state according to a pressure-temperature constitutional diagram (P-T constitutional diagram) of the compound semiconductor MₘXₙ, to grow the single crystal of the compound semiconductor MₘXₙ.

## Description

### Technical Field

The present invention relates to a process for producing a compound semiconductor single crystal and an apparatus therefor, which are used for manufacturing semiconductor devices, such as an optical device, an electronic device or the like, and a compound semiconductor single crystal. In particular, the present invention relates to a technique for producing a compound semiconductor single crystal effectively, which is applied to the solution growth method carried out by applying high voltage.

### Background of the Invention

Recently, a research in which a compound semiconductor single crystal is used as a semiconductor substrate and a component material, for manufacturing a semiconductor device, such as an optical device (for example, an optical waveguide circuit, an integrated optics or the like), an electronic device (for example, a laser diode, a HEMT or the like) or the like, has been carried out actively.

In particular, compound semiconductors, such as GaAs, GaN, GaP, InP, AlGaAs, InGaAsP, CdTe, or the like, have a higher light emission property and a higher electron mobility than Si. By using the above-described properties of the compound semiconductors, the elements having good properties which cannot be realized by Si, have been developed as a light emitting element, such as a laser diode or the like, and an ultra-high speed and high frequency element. As a result, parts of the elements are used practically.

For example, because GaN which is one of the nitride compound semiconductors has a wide forbidden band gap, GaN is expected as short wavelength light emitting devices and environment resistance devices and is researched actively.

According to an earlier development, the processes for producing these compound semiconductor single crystals are classified roughly into the melt growth method, the solution growth method and the vapor phase epitaxy method.

In the melt growth method, there are a Czochralski method (CZ method: Czochralski Method), a liquid encapsulated Czochralski method (LEC method: Liquid Encapsulated Czochralski Method), a vertical Bridgman method (VB method: Vertical Bridgman Method), a horizontal Bridgman method (HB method: Horizontal Bridgman method), a horizontal gradient freezing method (HGF method: Horizontal Gradient Freezing Method), a vertical gradient freezing method (VGF method: Vertical Gradient Freezing Method) and the like.

In the solution growth method, there are an SSD method (Synthesis by Solute Diffusion Method) and a THM method (Traveling Heater Method) in addition to a simple solution growth method in which a seed crystal is located in a solution obtained by solving material elements in a predetermined solvent and a supersaturated condition is caused by cooling the solution in order to grow the single crystal. In the vapor phase epitaxy method, there are a Piper Polich method, a chemical vapor deposition method (CVD: Chemical Vapor Deposition), a physical vapor deposition method (PVD: Physical Vapor Deposition) and the like.

The above-described LEC method is industrially used in order to grow the single crystal of the compound semiconductor, such as GaP, InP. GaAs or the like. The above-described HB method or the above-described HGF method is industrially used in order to grow the single crystal of GaAs or the like. The above-described VGF method is industrially used in order to grow the single crystal of GaAs, CdTe or the like.

However, when a crystal of a material in which the decomposition pressure of the component element of the compound semiconductor is extremely high is grown, because it is necessary to apply high voltage, the earlier process for growing a single crystal cannot be applied without carrying out a certain process or the single crystal having enough size cannot be obtained even though the earlier process can be applied.

That is, with respect to the compound semiconductor obtained by using the material in which the decomposition pressure of the component element is over 100 atm, there are extremely few successful cases in which the single crystal having enough size can be grown by any earlier process for growing a single crystal.

For example, GaN (gallium nitride) which is the Group III-V compound semiconductor has a wurtzite structure and is the direct transition type of semiconductor which has an energy gap of 3.39 V. The GaN has attracted the attention of the researchers as a compound semiconductor material of a light emitting diode (for example, a light emitting diode having a MIS structure) which can oscillate a blue light and of a laser diode (a semiconductor laser).

In case of the GaN, because it is difficult to grow a bulk crystal and a single crystal having a sufficient purity, which is used as a growth substrate (a seed crystal) cannot be obtained, the epitaxial growth of the GaN is carried out on a sapphire substrate, an SiC substrate or other oxide substrates to make a thin film.

However, in the above-described process for growing the GaN single crystal, there are problems that the growth rate is low and that many crystal defects having a range of from 10⁹ to 10¹⁰ cm⁻² are caused.

Although many crystal defects cause few problems when a blue light emitting diode is manufactured, the crystal defects cause seriously problems when a blue semiconductor laser which needs double-heterostructure or the like, is manufactured.

When the blue light emitting diode is manufactured by using the GaN obtained by carrying out the epitaxial growth on an oxide substrate, it is necessary to form electrodes on the epitaxial film because the oxide substrate is an insulator.

Because the area of one element is large, it is troublesome that the element cannot be small and that a circuit cannot be highly integrated. Because the process for manufacturing elements is complex, the cost for manufacturing elements increases. This problem is one of the causes that the cost of the blue light emitting diode or the like cannot be reduced.

Further, when the blue semiconductor laser is manufactured by using the GaN obtained by carrying out the epitaxial growth on an oxide substrate, there is a problem that the process for making a resonance plane is complex because a cleavage plane cannot be obtained.

Similarly to the above-described light emitting diode, because it is necessary to form electrodes on the epitaxial film, the area of one element is large. There are problems that the element cannot be small and that a circuit cannot be highly integrated.

From the reasons, it is requested that the above-described elements should be manufactured by using the substrate made of the GaN single crystal instead of the oxide substrate such as sapphire or the like, in order to solve the above-described problems and to manufacture the light emitting diode and the semiconductor laser, which can oscillate blue light having each superior characteristic.

However, because in the solution obtained by solving N (nitrogen) in a melt of Ga (gallium), the decomposition pressure of the component element is over 10,000 atm, it is extremely difficult to grow the GaN crystal.

Because the high pressure condition prevents the GaN single crystal from being grown directly, the substrate obtained by carrying out the epitaxial growth of the GaN thickly (for example, 20 µm thickness) on the sapphire substrate has attempted to be used as a makeshift.

However, in this process, it cannot be avoided that the dislocation in the crystal is propagated from the sapphire substrate. In order to reduce the dislocation density, a mask pattern (for example, a pattern having a thickness of 0.1 µm and a width of 8 µm at intervals of 4 µm in the resonant direction) having stripes is formed by using an SiO₂ and the GaN is grown in a transverse direction (a lateral direction). Thereby, the dislocation density can be reduced. A smooth surface having no threading dislocation caused by a difference in a lattice constant between the sapphire substrate and the GaN film, can be obtained.

In fact, in case of the GaN type of blue semiconductor laser formed on the GaN epitaxial film obtained by the above-described process, an effect that the life thereof becomes longer than 10,000 hours is confirmed.

However, in such a GaN thick epitaxial film, there is a problem that the process cost increases because the product process is complicated and complex. The situation in which the electrodes must be formed on the epitaxial films is not changed. The problems that because the area of one element is large, the element cannot be small and a circuit cannot be highly integrated, remain being still unsolved.

Although the GaN substrate is improved variously, it is necessary to develop the technology of growing the GaN single crystal as a substrate in order to solve the above-described various problems essentially.

Although as an attempt to grow the GaN single crystal, for example, the vapor phase epitaxy method or the Na flux method has been tested, the actual state is that the crystal having enough size cannot be obtained.

It has been attempted that the GaN single crystal is grown by the solution growth method under an ultra-high pressure of about 10,000 atm. Although the substrate having about 10 mm square can be obtained, the crystal having enough size to manufacture a light emitting diode or a semiconductor laser cannot be obtained efficiently. The actual state cannot be beyond the experimental level in which the GaN single crystal is slightly produced in the Ga solution.

The most important problem of the solution growth method is that when the crystal of the compound semiconductor is grown in the solution, the temperature of the solution is reduced by varying the composition thereof. Because of the compositional supercooling, it is difficult to grow the crystal.

When the GaN is grown in the solution, only part of the Ga solution is crystallized. Because much Ga remains as a residue, the yield of the material is low. The actual state is that the process cannot be industrially used, easily.

As the GaN which is the Group III-V compound semiconductor is exemplified above, although it is extremely important that the crystal to be made of the material in which the decomposition pressure of the component element of the compound semiconductor is over 100 atm is grown, the bulk single crystal having enough size to be useful in practice cannot be obtained by the earlier technology of growing crystals.

Further, there is a problem with respect to the crystallization of the GaN bulk single crystal obtained by the solution growth method under an ultra-high pressure.

That is, because there are various defects in the grown crystal, the characteristics of the device are influenced. When the defects caused by impurities are noticed, for example, it is suggested that oxygen causes the defect called nano-pipe. It is reported that because an oxygen atom causes the crystal growth to be terminated partially, a hollow pipe which is in nano-scale is caused in the crystal grown from the termination.

On the other hand, in case of the bulk GaN growth carried out by using the Ga solution, it is reported that the GaN crystal grown by the Ga solution including Mg is crystallized more than the crystal grown by the solution in which only Ga is solved.

As a result of studying the above-described phenomenon, the inventors thought that because Mg getters oxygen, the oxygen is not incorporated in the crystal even though the oxygen exists in the Ga solution.

Further, as a result of the consideration for the phenomenon, the inventors guess that by growing the crystal in a condition in which traces of elements which can easily react to the impurities to be removed exist in the Ga solution, it is possible that the impurities are prevented from being incorporated in the crystal.

However, when Mg is incorporated in the grown GaN crystal. the crystal cannot be used as a conductive substrate because the GaN crystal has a high resistivity. That is, Mg is not necessarily a superior gettering agent. Therefore, there is much possibility that a bad influence is caused by simply adding a gettering agent in the growth solution. It is concluded that this impurity removing method is not effective.

The invention studied about the above-described situations. As a result, the present invention was completed. The main object is to solve the above-described problems of the earlier technology of growing crystals, and to provide a novel process for producing a compound semiconductor single crystal and a novel apparatus therefor, which can grow the single crystal having enough size and a high purity by using the material in which the decomposition pressure of the component element of the compound semiconductor is over 100 atm, and a compound semiconductor single crystal having enough size to be useful in practice.

### Disclosure of the Invention

In order to accomplish the above-described object, in accordance with one aspect of the present invention, the process for producing compound semiconductor single crystal, in which a single crystal of a compound semiconductor MₘXₙ(where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises the steps of:
(1) introducing a container for growing crystals, in which a predetermined amount of the element M is put and the gas including the element X into a predetermined treatment chamber having a heating member and a pressurizing member;
(2) heating the element M in the container for growing crystals to a predetermined temperature by the heating member to melt the element M;
(3) applying a predetermined pressure to the gas including the element X by the pressurizing member to solve the gas in the melt of the element M; and
(4) further increasing a pressure of the gas including the element X by the pressurizing member while a temperature of the melt of the element M, in which the gas including the element X is solved is kept constant, and controlling the heating member and the pressurizing member so that conditions of a temperature and of a pressure can be in a stable domain as a solid state according to a pressure-temperature constitutional diagram (P-T constitutional diagram) of the compound semiconductor MₘXₙ, to grow the single crystal of the compound semiconductor MₘXₙ.

Instead of the step (4), the step may be "decreasing a temperature of the melt of the element M, in which the gas including the element X is solved, and controlling the heating member and the pressurizing member so that a pressure of the gas including the element X can at least exceed an equilibrium vapor pressure in a stable domain as a solid state according to a pressure-temperature constitutional diagram (P-T constitutional diagram) of the compound semiconductor MₘXₙ and preferably at the same time, the pressure of the gas can be kept constant, to grow the single crystal of the compound semiconductor MₘXₙ".

When the element M includes an impurity Y, a Z acting as a gettering agent for the impurity Y is preferably disposed in the treatment chamber.

The element M may be one selected from the group consisting of Zn, Cd and Hg which are the Group 12 (2B) elements of the periodic table or may be one selected from the group consisting of Al, Ga and In which are the Group 13 (3B) elements of the periodic table.

The element X may be one selected from the group consisting of N, P and As which are the Group 15 (5B) elements of the periodic table or may be one selected from the group consisting of O, S, Se and Te which are the Group 16 (6B) elements of the periodic table.

The gas including the element X may be one selected from the group consisting of N₂, NH₃ and O₂.

The compound semiconductor MₘXₙ may be one selected from the group consisting of GaN, AlN, InN and ZnO.

The impurity Y may be one selected from the group of H₂O and O. The Z acting as a gettering agent for the impurity Y may be one selected from the group of Ca, Mg, Li, Al, Ti, Si, V, Mn, Cr, Na, Zn and Fe, which does not influence the conductivity of the compound semiconductor single crystal or which can be carriers for a desirable type of semiconductor.

In this case, for example, the Al does not influence the conductivity of the GaN. The Si acts as a donor in the GaN. The Zn act as an acceptor therein. Therefore, the Z is selected from those elements according to a desirable type of semiconductor.

When the element is used as a gettering agent, it is not necessary to include the element in the Ga melt. If the element can be contact with the impurity to be removed, the gettering effect can be obtained effectively by even disposing the element in the atmosphere for growing crystals.

In this case, because these elements are not incorporated in the crystal to be grown, the gettering agent can be selected without depending on the type of semiconductor to be grown. In case of disposing the element in the atmosphere for growing crystals as described above, the Mg can be used.

As a seed crystal for growing the compound semiconductor MₘX_{n,} a single crystal substrate having a melting point which is higher than the growth temperature of the compound semiconductor MₘXₙ crystal to be grown, a different composition from the compound semiconductor MₘXₙ crystal and a low solubility in the melt of the element M may be used. In this case, a plurality of the single crystal substrates are used.

The single crystal substrate may be composed of one selected from the group consisting of a sapphire (aluminum oxide: Al₂O₃) substrate, an SiC substrate, MgAl₂O₄, MgO, ZnO, LiGaO₂, LiAlO₂, LiNbO₃, LiTaO₃, YAlO₃, ScAlMgO₄ and LaSrGaO₄.

The single crystal substrate may be a perovskite crystal substrate like NdGaO₃, LaAlO₃, LaTaO₃, SrAlO₃ and SrTaO₃.

The single crystal substrate may be an apatite crystal substrate like a Ca₈La₂(PO₄)₆O₂ substrate.

The size of a cluster of the compound semiconductor MₘXₙ may be reduced by keeping the melt of the element M at a temperature which is 50°C higher than an equilibrium temperature at which a solubility of the element X in the melt of the element M or that of the gas including the element X therein is a predetermined one, or by keeping at the equilibrium temperature for 12 hours or more.

In accordance with another aspect of the present invention, the apparatus for producing compound semiconductor single crystal, to which the above-described process for producing compound semiconductor single crystal is applied, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises: a treatment chamber formed by a high pressure cylinder; a container for growing crystals, which is disposed in the treatment chamber and in which a predetermined amount of the element M is put; a sealing member engaged with an upper position of the treatment chamber; a gas compressing member for introducing the gas including the element X into the treatment chamber, which is connected with the sealing member; a heating member for heating the container for growing crystals to a predetermined temperature to melt the element M in the container for growing crystals; a pressurizing member for increasing a pressure in the treatment chamber to a predetermined pressure to solve the gas including the element X in the melt of the element M; a controlling member for controlling the heating member and the pressurizing member so that a condition of a temperature of the container for growing crystals and that of a pressure can be in a stable domain as a solid state according to a pressure-temperature constitutional diagram (P-T constitutional diagram) of the compound semiconductor MₘXₙ.

The apparatus may be constructed so that the container for growing crystal is a crucible made by pBN, the sealing member is an upper plug having a high pressure gas inlet, the gas compressing member is a compressor having a pressure adjuster and a gas feed system, the heating member is a graphite heater, the pressurizing member is a piston having a lifting device, and the controlling member is a control device having a microcomputer.

In accordance with another aspect of the present invention, the compound semiconductor single crystal is a single crystal of a compound semiconductor MₘXₙ (where when an element M is a Group 13 (3B) element, an element X is nitrogen, or when an element M is a Group 12 (2B) element, an element X is oxygen, and m and n are integers which are 1 or more), wherein an element having an ionic radius which is smaller than that of either element between a component element M of the compound semiconductor MₘXₙ and a component element X thereof, or which is approximate to that of either element between the component element M of the compound semiconductor MₘXₙ and the component element X thereof, is added as an impurity, and the single crystal has an ingot form.

The element M may be Ga, and the impurity may be at least one selected from the consisting of Be, Mg, Zn, B, Al, C, Si and Ge. The element X may be N, and the impurity may be one selected from the group consisting of O and F.

The element M may be Zn, and the impurity may be at least one selected from the group consisting of Li, Be, B, Al, Ga, C, Si and Ge. The element X may be O, and the impurity may be F.

In accordance with another aspect of the present invention, the compound semiconductor single crystal comprises a Group 13 (3B) element of the periodic table and a Group 15 (5B) element thereof, wherein In is added as an impurity and the compound semiconductor single crystal has an ingot form having enough size to be useful in practice.

In particular, when the compound semiconductor single crystal is GaN or a compound of nitride, the impurity may be In.

When each type of semiconductor device, for example, a light emitting diode, a semiconductor laser or the like, which can oscillate a blue light, is manufactured in quantity, a wafer made of a compound semiconductor single crystal according to the present invention is suitable.

Hereinafter, the consideration for accomplishing the present invention by the inventors and the research therefor will be summarized.

In order to solve the above-described problem that the single crystal having enough size cannot be grown by using the material in which the decomposition pressure of the component element of the compound semiconductor is over 100 atm, the inventors have researched into the problem.

According to an earlier development, the principle of the process for growing crystals, such as a solution growth method or the like, is that in general, after the whole system is kept at a predetermined temperature, the crystal is deposited by cooling the system.

The principle of the process for growing crystal is used for all of the processes for growing crystals, such as the above-described earlier processes for growing crystals, which are a Czochralski method (CZ method), a liquid encapsulated Czochralski method (LEC method), a vertical Bridgman method (VB method), a horizontal Bridgman method (HB method), a horizontal gradient freezing method (HGF method), a vertical gradient freezing method (VGF method) and the like, a simple solution growth method, an SSD method, a THM method or the like.

In fact, in case of growing the GaN single crystal by the solution growth method under an ultra-high pressure of about 10,000 atm, after the temperature of the whole system is kept constant, the N (nitrogen) which was solved in a saturated condition is solved in a supersaturated condition by cooling the system. Because the crystal is deposited by using the principle, the crystal can be grown.

The most serious demerit of the process for growing crystal according to the principle, is that it is difficult to grow the single crystal so as to arrange the atoms regularly in the whole crystal. Although the whole system is stable at a constant temperature, the temperature atmosphere of the whole system is changed by the step of decreasing the temperature. As a result, the condition for growing the crystal is unstable.

Thereby, a distortion is caused in the crystal, or a crystal defect, such as a dislocation, is caused. The distortion and the crystal defect cause the performance of the element to be deteriorated and the life thereof to be shortened.

When the temperature of the system is decreased in the solution growth method, the melting point of the solution drops down by varying the composition of the solution with the crystal growth. Therefore, there is a problem that the compositional supercooling is easily caused. While the crystal is grown, the growth rate is exponentially decreased. The crystal growth is stopped substantially from a certain time. There is another problem that most of the solution material remains and becomes useless.

The inventors continued the research and the consideration in order to conquer the limitations of the process for growing the compound semiconductor single crystal, which was based on such an earlier principle. As a result, the process (process 1) for growing crystals, which is based on a new principle in which the temperature of the system is not decreased and the pressure of the system is raised, or the process (process 2) for growing crystals, which is based on a new principle in which the temperature of the system is decreased while the pressure of the system exceeds an equilibrium vapor pressure and preferably the pressure thereof is kept constant, is proposed by the present invention.

In addition to the two processes for growing crystals, it is proposed that the gettering agent is disposed in a position in which the gettering agent can be contact with the impurity sufficiently in order to reduce a crystal defect density of the crystal when the impurity to be removed exists in the material solution.

Further, in the above-described processes, the compound semiconductor single crystal which is produced by adding the impurity causing the crystal defect density to be reduced to the material solution, is proposed.

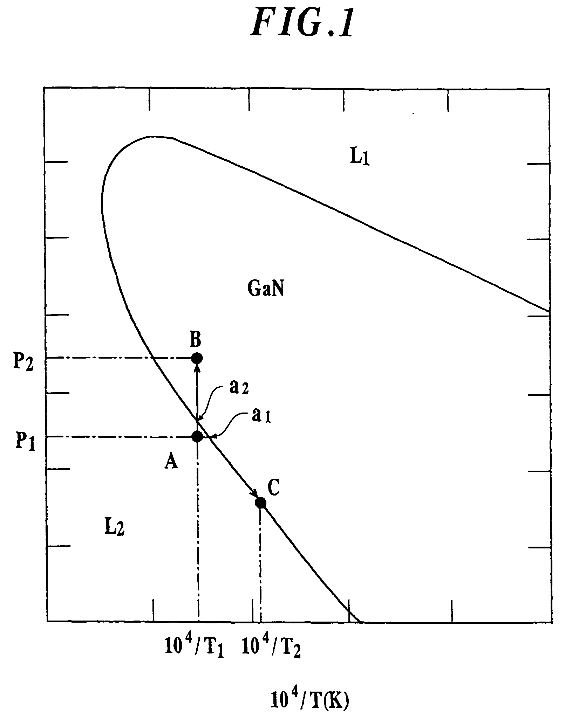

Hereinafter, the principles of the process for growing the crystal, which the inventors proposed will be explained in view of FIGS. 1 to 3.

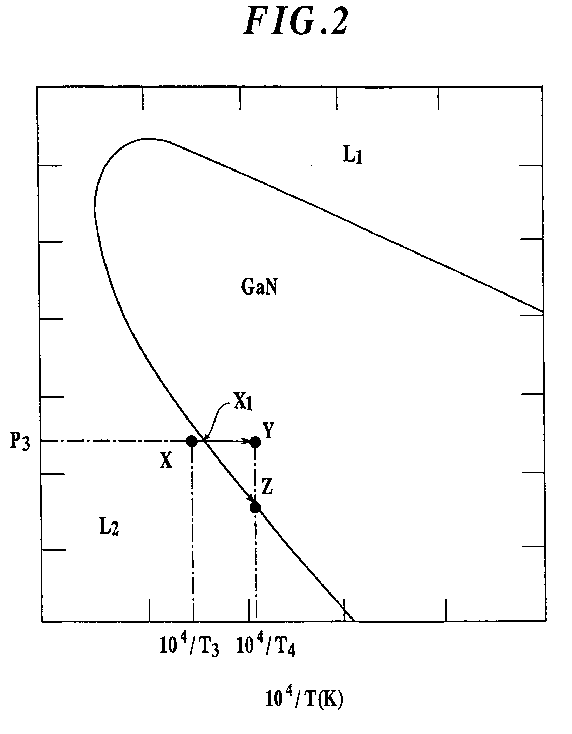

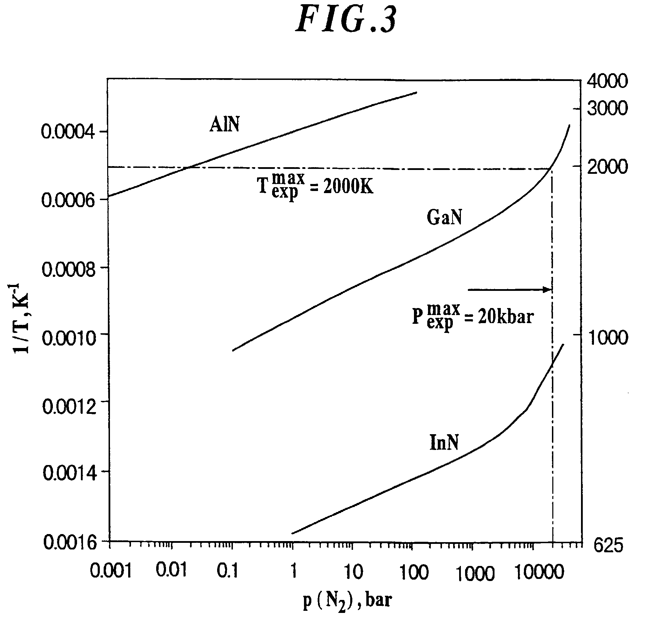

FIGS. 1 and 2 are schematic pressure-temperature constitutional diagrams (P-T constitutional diagrams) of GaN, and FIG. 3 is an actual pressure-temperature constitutional diagram of nitrides (Porowski et al. J. Cryst. Growth 178, 174 (1997)).

In the P-T constitutional diagrams of GaN shown in FIG. 1, at the predetermined temperature T1 at which the Ga can be melted, the pressure of the system is kept at the constant pressure P1. The system is set to the predetermined condition of the point A (the initial condition), in which the GaN is in a melt state.

In the earlier process for growing crystals, while the predetermined time passes, the condition of the system is changed from the point A to the point C by decreasing the temperature of the system from the temperature T1 to the temperature T2 without keeping the pressure P1 of the system. That is, while the condition is changed from the point A to the point C through the point a1, the condition reaches the solidus line of the GaN. Then, the crystal is grown by changing the condition along the solidus line.

However, the inventors studied the relation between the pressure condition and the temperature condition on the basis of the P-T constitutional diagrams of GaN, again. As a result, the inventors found that the supersaturated condition can be achieved in the system by increasing the pressure of the system without decreasing the temperature according to an earlier common knowledge.

That is, in FIG. 1, at the predetermined temperature T1 at which the Ga can be melted, the pressure of the system is kept at the constant pressure P1. The system is set to the predetermined condition of the point A (the initial condition), in which the GaN is in a melt state. Then, while the temperature is kept at the temperature T1, the pressure is raised from the pressure P1 to the predetermined pressure P2 by further increasing the pressure so that the system can be in a stable domain as a solid state of GaN. While the predetermined time passes, the condition of the system is changed from the point A which is the initial condition shown in FIG. 1 to the point B through the point a2. After the system reaches the solidus line of the GaN at the point a2, the Gall crystal is grown by keeping the system in the stable domain as a solid state of the GaN.

Further, the inventors studied the relation between the pressure condition and the temperature condition on the basis of the P-T constitutional diagrams of GaN, again. As a result, the inventors found that the same effect can be obtained by decreasing the temperature of the system in order to achieve the supersaturated condition in the system while the pressure of the system is kept.

That is, in FIG. 2, at the predetermined temperature T3 at which the Ga can be melted, the pressure of the system is kept at the constant pressure P3. The system is set to the predetermined condition of the point X (the initial condition), in which the GaN is in a melt state. Then, while the pressure is kept at the constant pressure P3, the temperature of the system is decreased to the temperature T4.

While the predetermined time passes, the condition of the system is changed from the point X which is the initial condition shown in FIG. 2 to the point Y through the point x1. After the system reaches the solidus line of the GaN at the point x1, the system is in the supersaturated condition (the point Y). The GaN crystal is grown by keeping the system in the stable domain as a solid state of the GaN.

Next, the reduction of the crystal defect density will be explained.

Various types of defects exist in the crystal grown by earlier solution growth method under an ultra-high pressure. The defects influence the characteristics of the device variously.

The above-described defects are caused by an impurity included in the material solution. That is, as described above, for example, when oxygen is included in the material solution, an oxygen atom causes the crystal growth to be terminated partially. A hollow pipe (nano-pipe) which is in nano-scale is formed in the crystal grown from the termination to cause the crystal defects.

The impurities can be prevented from being incorporated in the crystal by disposing a predetermined amount of element which can easily react to the impurities to be removed, which exist in the material solution. It is possible to reduce a crystal defect density more.

When the gettering agent is disposed in an atmosphere for growing crystal within an area in which the gettering agent can be contact with the impurity sufficiently, the gettering agent is not incorporated into the crystal. If the gettering agent can easily react to the impurity to be removed, the type of the gettering agent is not limited. When the gettering agent is disposed in the material solution, the element is preferably selected from ones which do not influence the conductivity of the compound semiconductor single crystal or which can be carriers for a desirable type of semiconductor.

Although the crystal defect density is reduced by removing the impurity in the material solution as described above, there is a method for reducing the crystal defect density by adding the impurity to the material solution on purpose in order to adjust the lattice constant.

The inventors considered this method for reducing the crystal defect density in case of the Group III-V compound semiconductor.

It is reported that in case of the III-V compound semiconductor, the crystal defect density can be reduced by adding the impurity which can harden the crystal according to an earlier development. For example, the crystal defect density of the GaAs crystal is effectively reduced by adding Si. The crystal defect density of the InP is effectively reduced by adding S or Zn. It is reported that a dislocation-free crystal can be grown by optimizing the growing condition.

However, it has been obvious that the lattice constant of the crystal is changed by adding the impurity when the crystal is hardened by the impurity.

Because the impurity having a small ionic radius and a large binding energy is used in order to harden the crystal, it is found that the lattice constant of the crystal is small.

For example, it becomes clear that the lattice constant of the GaN having nitrogen vacancies is larger than that of the crystal which is expected to be a perfect crystal.

The inventors studied on the basis of the reasoning that the lattice constant of the crystal can be equal to that of the perfect crystal by adjusting the lattice constant and a bulk crystal which can carry out homoepitaxy without causing the distortion or the dislocation in the crystal can be obtained when the element, like an impurity for hardening a crystal, which has a small ionic radius and a large binding energy is also adding to the compound semiconductor, such as a GaN or the like.

As a result, in case of the GaN, it is found that the lattice constant is effectively adjusted by adding B, Al or the like as an impurity, which has a small ionic radius and a large binding energy and which is the same group element as Ga.

When the n-type crystal is produced, C, Si, Ge or the like is added as an element for which Ga is substituted, or O, F or the like is added as an element for which N is substituted. Thereby, it is found that the distortion or the dislocation can be effectively prevented from being caused in the crystal.

When the p-type crystal is produced, Be, Ma, Zn or the like is added. Thereby, it is found that the distortion or the dislocation can be effectively prevented from being caused in the crystal.

Further, the inventors studied on the basis of the above-described finding. As a result, the inventors firmly believe that the lattice constants of other nitride compound semiconductors in addition to the GaN or those of other compound semiconductors can be effectively adjusted by adding the above-described impurity. The present invention can be accomplished.

In the compound semiconductor single crystal according to one aspect of the present invention, it is possible that the lattice constant of the above semiconductor is equal to that of a perfect crystal by adjusting the lattice constant. A bulk crystal (for example, a bulk crystal of the GaN) which can carry out homoepitaxy without causing the distortion or the dislocation in the crystal can be obtained.

When each type of semiconductor devices, for example, a light emitting diode, a semiconductor laser or the like, which can oscillate a blue light, is manufactured by using the substrate composed of the compound semiconductor single crystal according to the present invention, it is expected to dramatically improve the yield of the element and the manufacturing efficiency. It is possible to reduce the manufacturing cost. It can be promoted to reduce the costs of these elements.

Not only the lattice constant of the GaN but also those of other nitride compound semiconductors or those of other compound semiconductors can be effectively adjusted by adding the above-described impurity.

In the process for producing compound semiconductor single crystal and the apparatus therefor according to the present invention accomplished on the basis of the above-described principles found out by the inventors, it can be avoided that the whole system is unstable. The compound semiconductor single crystal can be grown in a stable condition.

It can be expected that the compound semiconductor single crystal (for example, GaN single crystal) having an enough size and high purity, which cannot be obtained by the earlier process for growing a crystal, can be grown.

In the present invention, because the constant pressure is applied or the pressure is kept constant, the composition of the solution (for example, Ga solution in which N is solved) can be always kept constant.

Because the melting point of the solution is always constant, the compositional supercooling is not caused. The composition of the solution can be kept constant while the crystal is grown. As a result, in principle, all of the solution (for example, Ga melt) can be changed into the compound semiconductor single crystal. It is expected that the yield of the material for the compound semiconductor becomes high.

When each type of semiconductor devices, for example, a light emitting diode, a semiconductor laser or the like, which can oscillate a blue light, is manufactured by using the compound semiconductor single crystal according to the present invention, it is expected to dramatically improve the manufacturing efficiency. It is possible to reduce the manufacturing cost. It can be promoted to reduce the costs of these elements.

### Brief Description of the Drawings

FIG. 1 is a schematic pressure-temperature constitutional diagram (P-T constitutional diagram) of GaN.
FIG. 2 is another schematic pressure-temperature constitutional diagram (P-T constitutional diagram) of GaN.
FIG. 3 is an actual pressure-temperature constitutional diagram (P-T constitutional diagram) of nitrides.
FIG. 4 is a structural view schematically showing the structure of the first embodiment of the crystal growing apparatus as an ultra-high pressure apparatus to which the process for producing the GaN single crystal according to the best mode of the invention is applied.
FIG. 5 is a structural view schematically showing the structure of the second embodiment of the crystal growing apparatus as an ultra-high pressure apparatus to which the process for producing the GaN single crystal according to the best mode of the invention is applied.
FIG. 6 is a structural view schematically showing the structure of the third embodiment of the crystal growing apparatus as an ultra-high pressure apparatus to which the process for producing the GaN single crystal according to the best mode of the invention is applied.
FIG. 7 is a structural view schematically showing an example of the structure in case of using a plurality of the single substrates as seed crystals.

### Best Mode of the Invention

Hereinafter, the preferred embodiments of the present invention will be explained.

### (First Embodiment)

In the present embodiment, as an example, GaN (gallium nitride) which is one of the most important compound semiconductor at present will be explained. The process for producing a compound semiconductor single crystal and the apparatus therefor, according to the present invention are not limited to the growth of the GaN single crystal. The process and the apparatus can be applied to every compound semiconductor in which the decomposition pressure of the component element is over 100 atm.

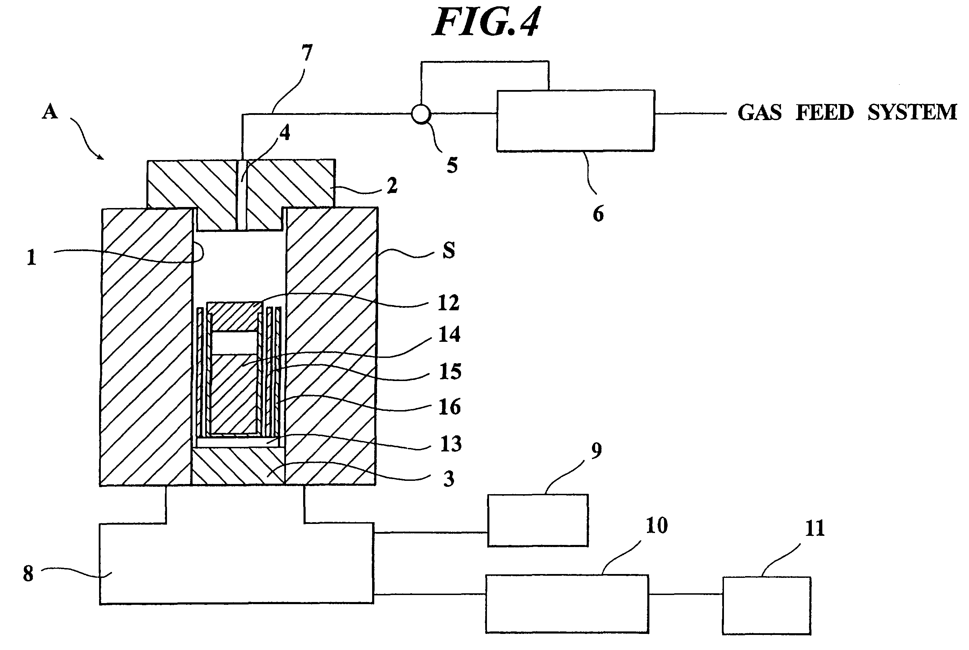

The structure of the first embodiment of the crystal growing apparatus as an ultra-high pressure apparatus to which the process for producing the GaN single crystal according to the present invention is applied will been explained in view of FIG. 4.

FIG. 4 is a structural view schematically showing the structure of the crystal growing apparatus as an example of the ultra-high pressure apparatus.

In FIG. 4, the reference A denotes a crystal growing apparatus body. The crystal growing apparatus body A comprises a treatment chamber 1 having a cylinder S which can withstand an ultra-high pressure, an upper plug 2 as a sealing member engaged with the upper part of the treatment chamber 1, and a piston 3 as a pressurizing member attached to the lower part of the treatment chamber 1 so as to be movable up and down.

In the upper plug 2, a high pressure nitrogen inlet 4 is provided as a high pressure gas inlet. As a gas compressing member, a compressor 6 is connected with the high pressure nitrogen inlet 4 through a pressure controller 5 by a pipe 7. The compressor 6 is connected with a gas feed system.

In the lower position of the piston 3, a piston lifting device 8 is provided as a driving portion. A vacuum pump 9 for removing the gas in the treatment chamber 1, a power supply 10 for supplying the power to the piston lifting device 8 and a control device 11 for controlling the lift of the piston 3 as a controlling member, which has, for example, a microcomputer, are connected with the piston lifting device 8.

The control device 11 suitably controls the operating status of the piston lifting device 8, the graphite heater 15 which will be explained below, or the like.

As a container for growing crystals, for example, a crucible 12 made by pBN and having an inner diameter of 48 mm is put in the treatment chamber 1. The crucible 12 is mounted on the upper surface of the piston 3 through an insulator 13.

As a compound semiconductor material 14, for example, Ga having a weight of 100 g is put into the crucible 12.

As a heating member, for example, a cylindrical two stage graphite heater 15 is provided around the crucible 12. The graphite heater 15 is connected with an electrode (not shown in the figure), which penetrates the piston 3 and the insulator 6.

As a temperature measuring member, a thermocouple 16 is provided along the outer surface of the graphite heater 15.

The above-described structure is a schematic one of the first embodiment of the crystal growing apparatus A as an ultra-high apparatus to which the process for producing the GaN single crystal according to the present embodiment is applied.

Hereinafter, a process for growing the GaN single crystal by using the crystal growing apparatus A will be explained simply.

As described above, as a compound semiconductor material 14, the Ga having a weight of 100 g is put into the crucible 12 to set it in the treatment chamber 1. The compressor 6 is powered on to introduce N₂ gas compressed to a pressure of 2,000 atm into the treatment chamber 1 through the high pressure nitrogen inlet 4. The piston lifting device 8 is driven by the control of the control device 11 to move up the piston 3. Thereby, the pressure in the treatment chamber 1 is raised to 7,000 atm.

The graphite heater 15 is energized to heat the treatment chamber 1 to 1,800 K. The Ga put into the crucible 12 is completely melted so as to be in a solution (a melt) state.

At the same time, the pressure in the treatment chamber 1 reaches 10,000 atm by heating the treatment chamber 1.

The lift of the piston 3 is finely adjusted by controlling the drive of the lifting device 8 so that the internal pressure of the Ga solution can be a predetermined one. The solution becomes in a condition in which the GaN crystal does not start to be deposited.

That is, in the P-T constitutional diagram (FIG. 1), the condition in the treatment chamber 1 is set to the condition of the point A (the initial condition), in which the temperature is T1 (1,800 K) and the GaN is in a melt state.

The treatment chamber 1 is kept in the condition for a predetermined time so as to sufficiently solve N (nitrogen) in the Ga solution. Then, the piston 3 is moved up by the control of the control device 11 to increase the pressure in the treatment chamber 1 by 1,000 atm. The total pressure in the treatment chamber 1 is 11,000 atm.

At the same time, the heating treatment carried out by the graphite heater 15 is controlled by the microcomputer of the control device 11 so that the temperature of the treatment chamber 1 can be kept at 1,800 K constantly on the basis of the temperature measurement information outputted from the thermocouple 16.

Therefore, in the P-T constitution diagram (FIG. 1), at the predetermined temperature T1 (1,800 K) at which the Ga can be melted, the pressure in the treatment chamber 1 is kept at the constant pressure P1 (10,000 atm + α). The system is set to the predetermined condition of the point A (the initial condition), in which the GaN is in a melt state. Then, while the temperature is kept at the temperature T1 (1,800 K), the pressure is raised from the pressure P1 to the predetermined pressure P2 (11,000 atm) by further increasing the pressure (by 1,000 atm) so that the system can be in a stable domain as a solid state of GaN. Thereby, the GaN is in the condition which is necessary for growing a crystal.

As a result, in FIG. 1, the condition of the Ga melt in which the N is solved is changed from the point A which is the initial condition to the point B through the point a2 while the predetermined time passes. The Ga solution filled in the crucible 12 is all changed into the GaN single crystal by keeping the system in the stable domain as a solid state of the GaN.

Although in the above-described embodiment, the pressure in the treatment chamber 1 is adjusted by the piston 3, the pressure of N₂ gas may be adjusted by the compressor 6 according to the pressurizing condition.

By growing the GaN single crystal with the above process, it is not necessary to vary the temperature of the Ga melt like an earlier process. Because it can be avoided that the condition for growing crystals is unstable, the GaN single crystal can be grown in a stable condition.

Therefore, the GaN single crystal having an ingot form and an enough size (in the present embodiment, the diameter thereof is 48 mm and the length thereof is 100 mm), which cannot be obtained by the earlier process for growing a crystal, can be grown.

In the present embodiment, because the constant pressure P2 is applied, the composition of the Ga melt in which N is solved can be kept constant. Because the melting point of the Ga solution is always constant, the compositional supercooling is not caused. The composition of the solution (the Ga melt in which N is solved) can be kept constant while the crystal is grown. As a result, all of the Ga melt can be changed into the GaN single crystal without a residue.

Therefore, when each type of semiconductor devices, for example, a light emitting diode, a semiconductor laser or the like. Which can oscillate a blue light, is manufactured by using the GaN single crystal obtained by the producing process according to the present embodiment, it is expected to dramatically improve the manufacturing efficiency as compared with the earlier process and to reduce the manufacturing cost. It is expected to reduce the cost of the blue light emitting diode or the like.

Although in the present embodiment, it is explained that the step of heating Ga to melt it and the step of introducing N₂ gas to increase the pressure are carried out non-simultaneously. the present invention is not limited this. These steps may be carried out simultaneously and in parallel.

Although it is explained that the GaN single crystal is grown by using the N₂ gas as a source of nitrogen, the present invention is not limited this. The liquid nitrogen or the compound, for example, NH₃ or the like, may be used as a source of nitrogen.

In the present embodiment, it is explained that as shown in the P-T constitutional diagram of the GaN (FIG. 1), after the condition in the treatment chamber 1 is set to the condition of the point A (the initial condition), in which the GaN is in a melt state at the temperature T1 (1,800 K), the condition in the treatment chamber 1 is changed to the point B at which the system is in a stable domain as a solid state of the GaN by further increasing the pressure. The present invention is not limited to this. In order to start to grow the crystal, the condition may be controlled so that the initial condition is directly set to the point B at which the system is in the stable domain as a solid state of the GaN without departing from the principle of the present invention and the gist thereof.

A sapphire (aluminum oxide: Al₂O₃) substrate having a melting point which is higher than the growth temperature of the GaN crystal to be grown, a different compound from the GaN crystal and a low solubility in the Ga melt may be used as a different type of seed crystal for crystallizing the GaN. In this case, because the specific gravity of sapphire is smaller than that of Ga, a proper holding member for the sapphire substrate is mounted on the bottom of the crucible 5 (for example, forming a seed crystal chamber which can be fixed to the bottom thereof by using a screw) preferably in order not to float the sapphire substrate on the Ga melt.

Further, a plurality of the above-described single crystal substrates can be used.

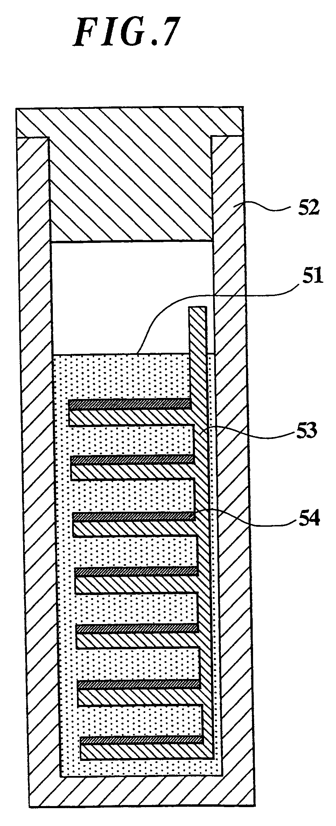

That is, for example, as shown in the schematic structural view (FIG. 7), a substrate holding member 53 on which a plurality of different types of single crystal substrates 54 can be mounted is disposed in a growth container 52. The substrate holding member 53 is sunk in a material solution 51. In such a structure, because a plurality of desired crystals can be grown once by the process for growing crystals and one process for growing crystals takes shorter time than that for growing a crystal having longitudinal ingot form, the production efficiency for the crystal can be improved.

The first embodiment is merely one of embodiments according to the present invention. The present invention is not limited to this. The process for producing the compound semiconductor single crystal according to the present invention can be also applied to other compound semiconductors in addition to the GaN single crystal.

That is, there is possibility that the present invention can be applied when the compound semiconductor single crystal to be grown by the process for producing a compound semiconductor single crystal according to the present invention is one of the MₘXₙ single crystals (where M is a Group 12 (2B) element of the periodic table or a Group 13 (3B) element thereof, X is a Group 15 (5B) element of the periodic table or a Group 16 (6B) element thereof, and m and n are integers which are 1 or more).

In particular, in case of the above-described element M, the element can be selected from the group consisting of Zn, Cd and Hg which are the Group 12 (2B) elements of the periodic table and Al, Ga and In which are the Group 13 (3B) elements of the periodic table.

In case of the above-described element X, the element can be selected from the group consisting of N, P and As which are the Group 15 (5B) elements of the periodic table and O, S, Se and Te which are the Group 16 (6B) elements of the periodic table.

In case of the gas including the above-described element X, the gas selected from the group including N₂, NH₃, O₂, H₂O, PH₃, AsH₃ or the like, can be used.

Although the above-described compound semiconductor MₘXₙ is not limited especially, as an example, AlN, InN, ZnO, GaAs, GaP, InP or the like can be given in addition to GaN according to the present embodiment. In particular, the present invention are preferably applied to the nitrides and the oxides, which are AlN, InN, ZnO and the like because the dissociation pressures of the Group V elements and those of the Group VI elements are high.

In the process for growing crystals, the temperature of the melt of the element M, in which the gas including the above-described element X is solved is kept constant. While the compound semiconductor MₘXₙ is in the stable domain, the temperature thereof is preferably high because the reaction rate is increased. However, it is difficult to determine the temperature simply because the temperature depends on the dissociation pressure of the compound semiconductor MₘXₙ, the performance of the crystal growing apparatus or the like. For example, in case of GaN, the temperature is in the range from 1,000 K to 2,800 K. Preferably, the temperature is in the range from 1,600 K to 2,800 K.

In the process for growing crystals, the pressure of the gas including the above-described element X is further increased by the pressurizing member. While the compound semiconductor MₘXₙ is in the stable domain, the pressure thereof is preferably high because the reaction rate is increased. However, similarly to the temperature, it is difficult to determine the pressure simply because the pressure depends on the dissociation pressure of the compound semiconductor MₘXₙ, the performance of the crystal growing apparatus or the like. For example, in case of GaN, the pressure is in the range from 2,000 atm to 45,000 atm. Preferably, the pressure is in the range from 10,000 atm to 45,000 atm.

A single crystal substrate having a melting point which is higher than the growth temperature of the compound semiconductor MₘXₙ crystal to be grown, a different composition from the compound semiconductor MₘXₙ crystal and a low solubility in the melt of the above-described element M may be used as a seed crystal for growing the above-described compound semiconductor MₘXₙ. In this case, a plurality of the above-described single crystal substrates can be used.

The process for producing a compound semiconductor single crystal according to the present invention can be applied to other solution growth methods, such as a flux method or the like.

### (Second Embodiment)

Next, the second embodiment of the present invention will be explained.

In the present embodiment, as an example, GaN (gallium nitride) which is one of the most important compound semiconductor at present will be explained. The process for producing a compound semiconductor single crystal according to the present invention are not limited to the growth of the GaN single crystal. The process can be applied to every compound semiconductor in which the decomposition pressure of the component element is over 100 atm.

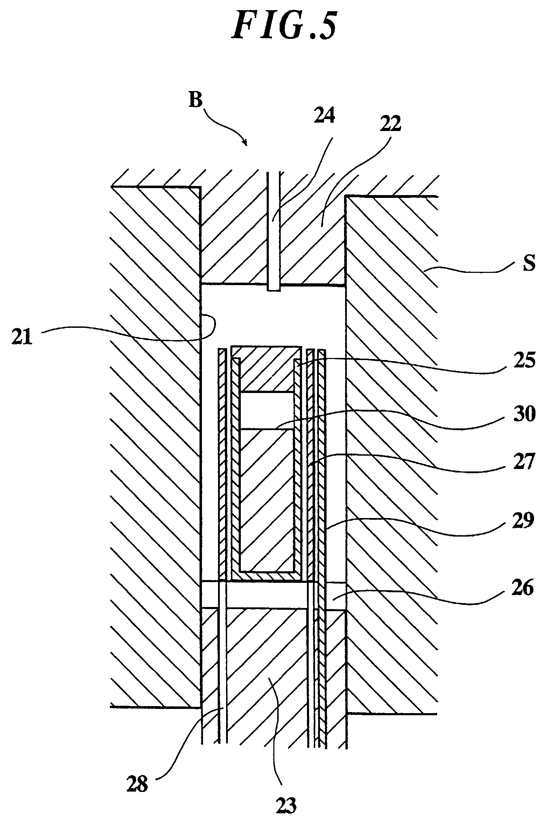

The structure of the crystal growing apparatus as an ultra-high pressure apparatus to which the process for producing the GaN single crystal according to the present invention can be applied will been explained in view of FIG. 5.

FIG. 5 is a cross-sectional view showing an schematic structure of the crystal growing apparatus as an ultra-high pressure apparatus.

In FIG. 5, the reference B denotes a crystal growing apparatus body. The crystal growing apparatus body B comprises a treatment chamber 21 having a cylinder S which can withstand an ultra-high pressure, an upper plug 22 engaged with the upper part of the treatment chamber 21, and a piston 23 as a pressurizing member attached to the lower part of the treatment chamber 21 so as to be movable up and down.

In the upper plug 22, a high pressure nitrogen inlet 24 is provided. As a pressurizing member, a compressor which is not shown in the figure is connected with the high pressure nitrogen inlet 24. In the lower position of the piston 23, a piston lifting device which is not shown in the figure is provided.

As a container for growing crystals, for example, a crucible 25 made by pBN and having an inner diameter of 48 mm is put in the treatment chamber 21. The crucible 25 is mounted on the upper surface of the piston 23 through an insulator 26.

As a compound semiconductor material 30, for example, Ga having a weight of 100 g is put into the crucible 25.

As a heating member, for example, a cylindrical two stage graphite heater 27 is provided around the crucible 25. The graphite heater 27 is connected with an electrode 28 which penetrates the piston 23 and the insulator 26.

As a temperature measuring member, a thermocouple 29 is provided along the outer surface of the graphite heater 27.

The piston lifting device, the compressor, the graphite heater 27, the thermocouple 29 and the like, are connected with a controlling member which has, for example, a microcomputer or the like, in order to suitably control each operating status.

The above-described structure is a schematic one of the second embodiment of the crystal growing apparatus B as an ultra-high apparatus to which the process for producing the GaN single crystal according to the present embodiment can be applied.

Hereinafter, a process for growing the GaN single crystal by using the crystal growing apparatus B will be explained simply.

As described above, as a compound semiconductor material 30, the Ga having a weight of 100 g is put into the crucible 25 to set it in the treatment chamber 21. The compressor is powered on to introduce N₂ gas compressed to a pressure of 2,000 atm into the treatment chamber 21 through the high pressure nitrogen inlet 24. The piston 23 is moved up to raise the pressure in the treatment chamber 1 to 7,000 atm.

The graphite heater 27 is energized to heat the treatment chamber 21 to 1,800 K through the electrode 28. The Ga put into the crucible 25 is completely melted so as to be in a solution (a melt) state.

At the same time, the pressure in the treatment chamber 21 reaches 10,000 atm by heating the treatment chamber 21.

The lift of the piston 23 is finely adjusted so that the internal pressure of the Ga can be a predetermined one. The solution becomes in a condition in which the GaN crystal does not start to be deposited.

That is, in the P-T constitutional diagram (FIG. 2), the condition in the treatment chamber 21 is set to the condition of the point X (the initial condition), in which the temperature is T3 (1,800 K) and the GaN is in a melt state.

The treatment chamber 21 is kept in the condition for a predetermined time so as to sufficiently solve N (nitrogen) in the Ga. Then, while the piston 23 is controlled to keep the pressure in the treatment chamber 21 constant (for example, 10,000 atm), the heating state of the graphite heater 27 is controlled on the basis of the temperature measurement information outputted from the thermocouple 29 in order to decrease the temperature of the treatment chamber 21 at a constant rate (for example. 1K/hr).

Therefore, in the P-T constitution diagram (FIG. 2), at the predetermined temperature T3 (1,800 K) at which the Ga can be melted, the pressure in the treatment chamber 21 is kept at the constant pressure P3 (10,000 atm). The system is set to the predetermined condition of the point X (the initial condition), in which the GaN is in a melt state. Then, while the pressure is kept at the constant pressure P3 (10,000 atm), the temperature of the Ga melt in which N is solved is decreased from the temperature T3 to the temperature T4 so that the system can be in a stable domain as a solid state of the GaN. Thereby, the GaN is in the condition which is necessary for growing a crystal.

As a result, in FIG. 2, the condition of the Ga melt in which the N is solved is changed from the point A which is the initial condition to the point Y through the point x1 while the predetermined time passes. The GaN single crystal can be obtained by keeping the system in the stable domain as a solid state of the GaN.

Although in the above-described embodiment, the pressure in the treatment chamber 21 is adjusted by the piston 23, the pressure of N₂ gas may be adjusted by the compressor according to the pressurizing condition.

By growing the GaN single crystal with the above process. because it can be avoided that the condition for growing crystals is unstable, the GaN single crystal can be grown in a stable condition.

Therefore, the GaN single crystal having an ingot form and an enough size, which cannot be obtained by the earlier process for growing a crystal, can be grown.

In the present embodiment, because the pressure in the treatment chamber 21 is kept at the constant pressure P3, the composition of the Ga melt in which N is solved can be kept constant. The compositional supercooling is not caused. All of the Ga melt can be changed into the GaN single crystal without a residue.

Therefore, when each type of semiconductor devices, for example, a light emitting diode, a semiconductor laser or the like, which can oscillate a blue light, is manufactured by using the GaN single crystal obtained by the producing process according to the present embodiment, it is expected to dramatically improve the manufacturing efficiency as compared with the earlier process and to reduce the manufacturing cost. It is expected to reduce the cost of the blue light emitting diode or the like.

Although in the present embodiment, it is explained that the step of heating Ga to melt it and the step of introducing N₂ gas to increase the pressure are carried out non-simultaneously, the present invention is not limited this. These steps may be carried out simultaneously and in parallel.

Although it is explained that the GaN single crystal is grown by using the N₂ gas as a source of nitrogen, the present invention is not limited this. The compound, for example, NH₃ or the like, may be used as a source of nitrogen.

In the present embodiment, it is explained that as shown in the P-T constitutional diagram of the GaN (FIG. 2), after the condition in the treatment chamber 21 is set to the condition of the point X (the initial condition), in which the GaN is in a melt state at the temperature T3 (1,800 K), the condition in the treatment chamber 21 is changed to the point Y at which the system is in a stable domain as a solid state of the GaN by further increasing the pressure. The present invention is not limited to this. In order to start to grow the crystal, the condition may be controlled so that the initial condition is directly set to the point Y at which the system is in the stable domain as a solid state of the GaN without departing from the principle of the present invention and the gist thereof.

A sapphire (aluminum oxide: Al₂O₃) substrate having a melting point which is higher than the growth temperature of the GaN crystal to be grown, a different compound from the GaN crystal and a low solubility in the Ga melt may be used as a different type of seed crystal for crystallizing the GaN. In this case, because the specific gravity of sapphire is smaller than that of Ga, a proper holding member for the sapphire substrate is mounted on the bottom of the crucible 5 (for example, forming a seed crystal chamber which can be fixed to the bottom thereof by using a screw) preferably in order not to float the sapphire substrate on the Ga melt. Further, a plurality of the above-described single crystal substrates can be used.

The above-described embodiment is merely one of embodiments according to the present invention. The present invention is not limited to this. The process for producing the compound semiconductor single crystal according to the present invention can be also applied to other compound semiconductors in addition to the GaN single crystal.

That is, there is possibility that the present invention can be applied when the compound semiconductor single crystal to be grown by the process for producing a compound semiconductor single crystal according to the present invention is one of the MₘXₙ single crystals (where M is a Group 12 (2B) element of the periodic table or a Group 13 (3B) element thereof, X is a Group 15 (5B) element of the periodic table or a Group 16 (6B) element thereof, and m and n are integers which are 1 or more).

In particular, in case of the above-described element M, the element can be selected from the group consisting of Zn, Cd and Hg which are the Group 12 (2B) elements of the periodic table and Al, Ga and In which are the Group 13 (3B) elements of the periodic table.

In case of the above-described element X, the element can be selected from the group consisting of N, P and As which are the Group 15 (5B) elements of the periodic table and O, S, Se and Te which are the Group 16 (6B) elements of the periodic table.

In case of the gas including the above-described element X, the gas selected from the group including N₂, NH₃, O₂, H₂O, PH₃, AsH₃ or the like, can be used.

Although the above-described compound semiconductor MₘXₙ is not limited especially, as an example, AlN, InN, ZnO, GaAs, GaP, InP or the like can be given in addition to GaN according to the present embodiment. In particular, the present invention are preferably applied to the nitrides and the oxides, which are AlN, InN, ZnO and the like because the dissociation pressures of the Group V elements and those of the Group VI elements are high.

Although in the process for growing crystals, the pressure of the gas including the above-described element X is preferably kept constant precisely, some fluctuation of the pressure can be allowed without departing from the gist of the present invention.

In the process for growing crystals, the temperature of the melt of the element M is decreased at a constant rate. However, it is difficult to determine the rate simply because the rate depends on the composition of the compound semiconductor MₘXₙ. For example, in case of GaN, the rate is in the range from 0.1K/hr to 10 K/hr. Preferably, the rate is in the range from 0.5K/hr to 3K/hr.

A single crystal substrate having a melting point which is higher than the growth temperature of the compound semiconductor MₘXₙ crystal to be grown, a different composition from the compound semiconductor MₘXₙ crystal and a low solubility in the melt of the above-described element M may be used as a seed crystal for growing the above-described compound semiconductor MₘXₙ. A plurality of the above-described single crystal substrates can be used.

The process for producing a compound semiconductor single crystal according to the present invention can be applied to other solution growth methods, such as a flux method or the like.

### (Third Embodiment)

In the present embodiment, as an example, GaN (gallium nitride) which is one of the most important compound semiconductor at present will be explained. The process for producing a compound semiconductor single crystal and the apparatus therefor, according to the present invention are not limited to the growth of the GaN single crystal. The process and the apparatus can be applied to every compound semiconductor in which the decomposition pressure of the component element is over 100 atm.

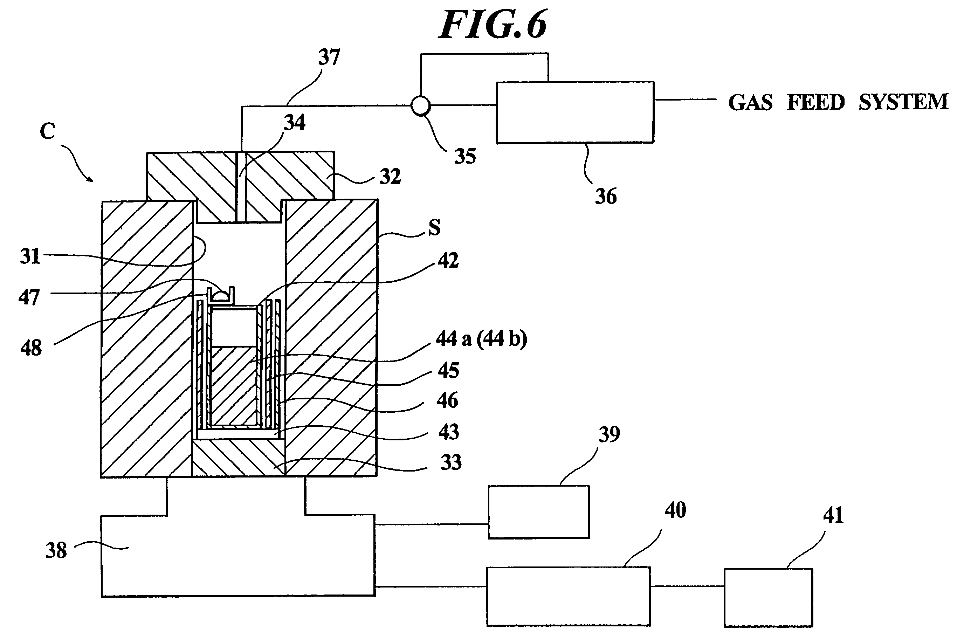

The structure of the crystal growing apparatus as an ultra-high pressure apparatus to which the process for producing the GaN single crystal according to the present invention is applied will been explained in view of FIG. 6.

FIG. 6 is a structural view schematically showing the structure of the third embodiment of the crystal growing apparatus as an ultra-high pressure apparatus.

In FIG. 6, the reference C denotes a crystal growing apparatus body. The crystal growing apparatus body C comprises a treatment chamber 31 having a cylinder S which can withstand an ultra-high pressure, an upper plug 32 as a sealing member engaged with the upper part of the treatment chamber 31, and a piston 33 as a pressurizing member attached to the lower part of the treatment chamber 31 so as to be movable up and down.

In the upper plug 32, a high pressure nitrogen inlet 34 is provided as a high pressure gas inlet. As a gas compressing member, a compressor 36 is connected with the high pressure nitrogen inlet 34 through a pressure controller 35 by a pipe 37. The compressor 36 is connected with a gas feed system.

In the lower position of the piston 33, a piston lifting device 38 is provided as a driving portion. A vacuum pump 39 for removing the gas in the treatment chamber 31, a power supply 40 for supplying the power to the piston lifting device 38 and a control device 41 for controlling the lift of the piston 33 as a controlling member, which has, for example, a microcomputer, are connected with the piston lifting device 38.

The control device 41 suitably controls the operating status of the piston lifting device 38, the graphite heater 45 which will be explained below, or the like.

As a container for growing crystals, for example, a crucible 42 made by pBN and having an inner diameter of 48 mm is put in the treatment chamber 31. The crucible 42 is mounted on the upper surface of the piston 33 through an insulator 43.

For example, as a compound semiconductor material 44a, Ga having a weight of 100 g and as an additional impurity 44b, boron (B) having a weight of 16 mg are put into the crucible 42.

As a heating member, for example, a cylindrical two stage graphite heater 45 is provided around the crucible 42. The graphite heater 45 is connected with an electrode (not shown in the figure), which penetrates the piston 33 and the insulator 46.

As a temperature measuring member, a thermocouple 46 is provided along the outer surface of the graphite heater 45.

Further, as gettering agents 47, for example, Ti powder, Mg powder and the like are put in a boat 48 for a gettering agent, which is made of graphite and is mounted on the upper position of the crucible 42.

The above-described structure is a schematic one of the embodiment of the crystal growing apparatus C as an ultra-high apparatus to which the process for producing the GaN single crystal according to the present embodiment is applied.

Hereinafter, a process for growing the GaN single crystal by using the crystal growing apparatus C will be explained simply.

As described above, as a compound semiconductor material 44a, the Ga having a weight of 100 g and as an additional impurity 44b, the B having a weight of 16 mg are put into the crucible 42 to set them in the treatment chamber 31. The compressor 36 is powered on to introduce N₂ gas compressed to a pressure of 2,000 atm into the treatment chamber 31 through the high pressure nitrogen inlet 34. The piston lifting device 38 is driven by the control of the control device 41 to move up the piston 33. Thereby. the pressure in the treatment chamber 31 is raised to 7,000 atm.

The graphite heater 45 is energized to heat the treatment chamber 31 to 1,800 K. The Ga and the B put into the crucible 42 are completely melted so as to be in a solution (a melt) state.

At the same time, the pressure in the treatment chamber 31 reaches 10,000 atm by heating the treatment chamber 31.

The lift of the piston 33 is finely adjusted by controlling the drive of the lifting device 38 so that the internal pressure of the Ga and B solution can be a predetermined one. The solution becomes in a condition in which the GaN crystal does not start to be deposited.

That is, in the P-T constitutional diagram (FIG. 1), the condition in the treatment chamber 31 is set to the condition of the point A (the initial condition), in which the temperature is T1 (1,800 K) and the GaN is in a melt state.

The treatment chamber 31 is kept in the condition for a predetermined time so as to sufficiently solve N (nitrogen) in the Ga and B solution. Then, the piston 33 is moved up by the control of the control device 41 to increase the pressure in the treatment chamber 31 by 1,000 atm. The total pressure in the treatment chamber 31 is 11,000 atm.

At the same time, the heating treatment carried out by the graphite heater 45 is controlled by the microcomputer of the control device 41 so that the temperature of the treatment chamber 31 can be kept at 1,800 K constantly on the basis of the temperature measurement information outputted from the thermocouple 46.

Therefore, in the P-T constitution diagram (FIG. 1), at the predetermined temperature T1 (1,800 K) at which the Ga can be melted, the pressure in the treatment chamber 1 is kept at the constant pressure P1 (10,000 atm + α). The system is set to the predetermined condition of the point A (the initial condition), in which the GaN is in a melt state. Then, while the temperature is kept at the temperature T1 (1,800 K), the pressure is raised from the pressure P1 to the predetermined pressure P2 (11,000 atm) by further increasing the pressure (by 1,000 atm) so that the system can be in a stable domain as a solid state of the GaN. Thereby, the GaN is in the condition which is necessary for growing a crystal.

As a result, in FIG. 1, the condition of the Ga melt to which the B is added and in which the N is solved is changed from the point A which is the initial condition to the point B through the point a2 while the predetermined time passes. The Ga solution filled in the crucible 42 is all changed into the GaN single crystal by keeping the system in the stable domain as a solid state of the GaN.

Because the X-ray diffraction peak width at half height of the obtained GaN single crystal is decreased about in half in comparison with that of a GaN single crystal obtained without using a gettering agent, it is confirmed that the crystallization of the obtained GaN single crystal is improved clearly.

It is thought that the above phenomenon is caused for the following reasons. The Ti powder, Mg powder and the like which are disposed as gettering agents 47 are included in the GaN solution. The powders react to oxygen (existing as H₂O or O) which is diffused in the atmosphere so as to remove the oxygen atoms. As a result, the oxygen can be prevented from being incorporated in the grown GaN single crystal effectively. The crystal having a high purity can be obtained without changing the physical characteristics of the crystal.

Although in the above-described embodiment, the pressure in the treatment chamber 31 is adjusted by the piston 33, the pressure of N₂ gas may be adjusted by the compressor 36 according to the pressurizing condition.

By growing the GaN single crystal with the above process, it is not necessary to vary the temperature of the Ga melt like an earlier process. Because it can be avoided that the condition for growing crystals is unstable, the GaN single crystal can be grown in a stable condition.

Therefore, the GaN single crystal having an ingot form and an enough size, which cannot be obtained by the earlier process for growing a crystal, can be grown.

In the present embodiment, because the constant pressure P2 is applied, the composition of the Ga melt in which N is solved can be kept constant. Because the melting point of the Ga solution is always constant, the compositional supercooling is not caused. The composition of the solution (the Ga melt in which N is solved) can be kept constant while the crystal is grown. As a result, all of the Ga melt can be changed into the GaN single crystal without a residue.

Therefore, when each type of semiconductor devices, for example, a light emitting diode, a semiconductor laser or the like, which can oscillate a blue light, is manufactured by using the GaN single crystal obtained by the producing process according to the present embodiment, it is expected to dramatically improve the manufacturing efficiency as compared with the earlier process and to reduce the manufacturing cost. It is expected to reduce the cost of the blue light emitting diode or the like.

Although in the present embodiment, it is explained that the step of heating Ga to melt it and the step of introducing N₂ gas to increase the pressure are carried out non-simultaneously, the present invention is not limited this. These steps may be carried out simultaneously and in parallel.

Although it is explained that the GaN single crystal is grown by using the N₂ gas as a source of nitrogen, the present invention is not limited this. The liquid nitrogen or the compound, for example, NH₃ or the like, may be used as a source of nitrogen.

In the present embodiment, it is explained that as shown in the P-T constitutional diagram of the GaN (FIG. 1), after the condition in the treatment chamber 31 is set to the condition of the point A (the initial condition), in which the GaN is in a melt state at the temperature T1 (1,800 K), the condition in the treatment chamber 31 is changed to the point B at which the system is in a stable domain as a solid state of the GaN by further increasing the pressure. The present invention is not limited to this. In order to start to grow the crystal, the condition may be controlled so that the initial condition is directly set to the point B at which the system is in the stable domain as a solid state of the GaN without departing from the principle of the present invention and the gist thereof.

A sapphire (aluminum oxide: Al₂O₃) substrate having a melting point which is higher than the growth temperature of the GaN crystal to be grown, a different compound from the GaN crystal and a low solubility in the Ga melt may be used as a different type of seed crystal for crystallizing the GaN. In this case, because the specific gravity of sapphire is smaller than that of Ga, a proper holding member for the sapphire substrate is mounted on the bottom of the crucible 45 (for example, forming a seed crystal chamber which can be fixed to the bottom thereof by using a screw) preferably in order not to float the sapphire substrate on the Ga melt. Further, a plurality of the above-described single crystal substrates can be used.

The above-described embodiment is merely one of embodiments according to the present invention. The present invention is not limited to this. The process for producing the compound semiconductor single crystal according to the present invention can be also applied to other compound semiconductors in addition to the GaN single crystal.

That is, there is possibility that the present invention can be applied when the compound semiconductor single crystal to be grown by the process for producing a compound semiconductor single crystal according to the present invention is one of the MₘXₙ single crystals (where M is a Group 12 (2B) element of the periodic table or a Group 13 (3B) element thereof, X is a Group 15 (5B) element of the periodic table or a Group 16 (6B) element thereof, and m and n are integers which are 1 or more).

In particular, in case of the above-described element M, the element can be selected from the group consisting of Zn, Cd and Hg which are the Group 12 (2B) elements of the periodic table and Al, Ga and In which are the Group 13 (3B) elements of the periodic table.

In case of the above-described element X, the element can be selected from the group consisting of N. P and As which are the Group 15 (5B) elements of the periodic table and O, S, Se and Te which are the Group 16 (6B) elements of the periodic table.

In case of the gas including the above-described element X, the gas selected from the group including N₂, NH₃, O₂, H₂O, PH₃, AsH₃ or the like, can be used.

Although the above-described compound semiconductor MₘXₙ is not limited especially, as an example, AlN, InN, ZnO, GaAs, GaP, InP or the like can be given in addition to GaN according to the present embodiment. In particular, the present invention are preferably applied to the nitrides and the oxides, which are AlN, InN, ZnO and the like because the dissociation pressures of the Group V elements and those of the Group VI elements are high.

In the process for growing crystals, the temperature of the melt of the element M, in which the gas including the above-described element X is solved is kept constant. While the compound semiconductor MₘXₙ is in the stable domain, the temperature thereof is preferably high because the reaction rate is increased. However, it is difficult to determine the temperature simply because the temperature depends on the dissociation pressure of the compound semiconductor MₘXₙ, the performance of the crystal growing apparatus or the like. For example, in case of GaN, the temperature is in the range from 1,000 K to 2,800 K. Preferably, the temperature is in the range from 1,600 K to 2,800 K.

In the process for growing crystals, the pressure of the gas including the above-described element X is further increased by the pressurizing member. While the compound semiconductor MₘXₙ is in the stable domain, the pressure thereof is preferably high because the reaction rate is increased. However, similarly to the temperature, it is difficult to determine the pressure simply because the pressure depends on the dissociation pressure of the compound semiconductor MₘX_{n,} the performance of the crystal growing apparatus or the like. For example, in case of GaN, the pressure is in the range from 2,000 atm to 45,000 atm. Preferably, the pressure is in the range from 10,000 atm to 45,000 atm.

A single crystal substrate having a melting point which is higher than the growth temperature of the compound semiconductor MₘXₙ crystal to be grown, a different composition from the compound semiconductor MₘXₙ crystal and a low solubility in the melt of the above-described element M may be used as a seed crystal for growing the above-described compound semiconductor MₘXₙ.

More concretely, in case of any one of the above-described first to third embodiments, as a seed crystal, the single crystal substrate is not limited to a sapphire (aluminum oxide: Al₂O₃) substrate. The substrate can be composed of a compound selected from the group consisting of SiC, MgAl₂O₄, MgO, ZnO, LiAlO₂, LiAlO₂. LiNbO₃, LiTaO₃, YAlO₃, ScAlMaO₄ and LaSrGaO₄.

Further, the above-described single crystal substrate can be composed of a perovskite crystal substrate. More concretely, as a perovskite crystal substrate, a compound selected from the group consisting of NdGaO₃, LaAlO₃, LaTaO₃, SrAlO₃ and SrTaO₃ can be used.

The above-described single crystal substrate can be composed of an apatite crystal substrate. More concretely, the above-described apatite crystal substrate can be a Ca₈La₂(PO₄)₆O₂ substrate.

The process for producing a compound semiconductor single crystal according to the present invention can be applied to other solution growth methods, such as a flux method or the like.

Although in the present embodiment, it is described that the boron (B) is added as an impurity, the present invention is not limited to this. The element having an ionic radius which is smaller than that of either element between the component element M of the compound semiconductor MₘXₙ and the component element X thereof, or which is approximate to that of either element between the component element M of the compound semiconductor MₘXₙ and the component element X thereof, may be added.

More concretely, when the above-described element M is Ga, at least one element selected from the group consisting of Be, Mg, Zn, B, Al, C, Si, Ge and In can be added as an impurity.

When the above-described element X is nitrogen (N), the above-described impurity may be an element selected from the group of O and F.

Further, when the above-described element M is zinc (Zn), the above-described impurity may be at least one element selected from the group consisting of Li, Be, B, Al, Ga, C, Si and Ge.

When the above-described element X is oxygen (O), the above-described impurity may be F.

Although in the present embodiment, it is explained that Ti powder, Mg powder and the like are used as gettering agents 47 for gettering oxygen included in the GaN solution, the present invention is not limited to this. In the compound semiconductor MₘXₙ, when the above-described element M includes the impurity Y, any Z which acts as a gettering agent for the above-described impurity Y may be disposed in the treatment chamber.

More concretely, the above-described Z which acts as a gettering agent may be one selected from the group consisting of Ca, Mg, Li, Al, Ti, Si, V, Mn, Cr, Na, Zn and Fe.

In case of any one of the above-described first to third embodiments, the melt of the above-described element M is kept at the temperature which is 50°C higher than an equilibrium temperature at which the solubility of the element X in the melt of the element M or that of the gas including the element X therein is a predetermined one, or is kept at the equilibrium temperature for 12 hours or more. Thereby, the size of a cluster of the above-described compound semiconductor MₘXₙ can be reduced.

By reducing the size of the cluster sufficiently in such a method, heterogeneous nucleuses can be prevented from being formed. Because the single crystals can be obtained easily, it is effective that the yield thereof becomes high and the diameter of the wafer can be large.

In case of any one of the above-described first to third embodiments, the GaN powder can be solved in the Ga melt in a saturated condition. In this case, the consumption of nitrogen in the growth atmosphere can be reduced by the amount of N with which the Ga melt is previously saturated. When the nitrogen gas is used by the same amount as the reduced consumption of nitrogen, more longitudinal crystal can be grown.

As described above, the N₂ gas compressed by powering on the compressor 6 or 36 through the high pressure nitrogen inlet 4 or 34 and introduced into the treatment chamber 1 or 31, is used as an N₂ source. However, the present invention is not limited to this. It is thought that liquid nitrogen is introduced into the treatment chamber and high pressure N₂ gas generated by the liquid nitrogen is directly used.

### Industrial Applicability

According to the present invention, the process for producing compound semiconductor single crystal, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises the steps of:
(1) introducing a container for growing crystals, in which a predetermined amount of the element M is put and the gas including the element X into a predetermined treatment chamber having a heating member and a pressurizing member;
(2) heating the element M in the container for growing crystals to a predetermined temperature by the heating member to melt the element M;
(3) applying a predetermined pressure to the gas including the element X by the pressurizing member to solve the gas in the melt of the element M; and
(4) further increasing a pressure of the gas including the element X by the pressurizing member while a temperature of the melt of the element M, in which the gas including the element X is solved is kept constant, and controlling the heating member and the pressurizing member so that conditions of a temperature and of a pressure can be in a stable domain as a solid state according to a pressure-temperature constitutional diagram (P-T constitutional diagram) of the compound semiconductor MₘXₙ, to grow the single crystal of the compound semiconductor MₘXₙ. According to another aspect of the present invention, the apparatus for producing compound semiconductor single crystal, to which the above-described process for producing compound semiconductor single crystal is applied, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises:
   a treatment chamber formed by a high pressure cylinder;
   a container for growing crystals, which is disposed in the treatment chamber and in which a predetermined amount of the element M is put;
   a sealing member engaged with an upper position of the treatment chamber;
   a gas compressing member for introducing the gas including the element X into the treatment chamber, which is connected with the sealing member;
   a heating member for heating the container for growing crystals to a predetermined temperature to melt the element M in the container for growing crystals;
   a pressurizing member for increasing a pressure in the treatment chamber to a predetermined pressure to solve the gas including the element X in the melt of the element M;
   a controlling member for controlling the heating member and the pressurizing member so that a condition of a temperature of the container for growing crystals and that of a pressure can be in a stable domain as a solid state according to a pressure-temperature constitutional diagram (P-T constitutional diagram) of the compound semiconductor MₘXₙ.

In the process for producing compound semiconductor single crystal according to the present invention, because it is not necessary to vary the temperature of the system like an earlier process, it can be avoided that the whole system is unstable. The compound semiconductor single crystal can be grown in a stable condition.

The process has an advantage that the compound semiconductor single crystal (for example, GaN single crystal) having an enough size, which cannot be obtained by the earlier process for growing a crystal, can be grown.

In the present invention, because the constant pressure is applied, the composition of the solution can be always kept constant. Because the melting point of the solution is always constant, the compositional supercooling is not caused. The composition of the solution can be kept constant while the crystal is grown. As a result, in principle, all of the solution can be changed into the compound semiconductor single crystal. It is expected that the yield of the material for the compound semiconductor becomes high.

When each type of semiconductor devices, for example, a light emitting diode, a semiconductor laser or the like, which can oscillate a blue light, is manufactured by using the compound semiconductor single crystal obtained by the process for producing compound semiconductor single crystal and the apparatus therefor according to the present invention, it is expected to dramatically improve the manufacturing efficiency. It is possible to reduce the manufacturing cost. It can be promoted to reduce the costs of these elements.

According to another aspect of the present invention, because the process for producing compound semiconductor single crystal, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprises the steps of:
(1) introducing a container for growing crystals, in which a predetermined amount of the element M is put and the gas including the element X into a predetermined treatment chamber having a heating member and a pressurizing member;
(2) heating the element M in the container for growing crystals to a predetermined temperature by the heating member to melt the element M;
(3) applying a predetermined pressure to the gas including the element X by the pressurizing member to solve the gas in the melt of the element M; and
(4) decreasing a temperature of the melt of the element M, in which the gas including the element X is solved, and controlling the heating member and the pressurizing member so that a pressure of the gas including the element X can at least exceed an equilibrium vapor pressure in a stable domain as a solid state according to a pressure-temperature constitutional diagram (P-T constitutional diagram) of the compound semiconductor MₘXₙ and preferably at the same time, the pressure of the gas can be kept constant, to grow the single crystal of the compound semiconductor MₘXₙ, it can be avoided that the whole system is unstable. The compound semiconductor single crystal can be grown in a stable condition.

The process has an advantage that the compound semiconductor single crystal (for example, GaN single crystal) having an enough size and an ingot form, which cannot be obtained by the earlier process for growing a crystal, can be grown.

In the present invention, because the pressure is kept constant, the composition of the solution can be always kept constant. In principle, all of the solution can be changed into the compound semiconductor single crystal. It is expected that the yield of the material for the compound semiconductor becomes high.

When each type of semiconductor devices, for example, a light emitting diode, a semiconductor laser or the like, which can oscillate a blue light, is manufactured by using the compound semiconductor single crystal obtained by the process for producing compound semiconductor single crystal according to the present invention, it is expected to dramatically improve the manufacturing efficiency. It is possible to reduce the manufacturing cost. It can be promoted to reduce the costs of these elements.

According to another aspect of the present invention, because the compound semiconductor single crystal is a single crystal of a compound semiconductor MₘXₙ (where when an element M is a Group 13 (3B) element, an element X is nitrogen, or when an element M is a Group 12 (2B) element, an element X is oxygen, and m and n are integers which are 1 or more), wherein an element having an ionic radius which is smaller than that of either element between a component element M of the compound semiconductor MₘXₙ and a component element X thereof, or which is approximate to that of either element between the component element M of the compound semiconductor MₘXₙ and the component element X thereof, is added as an impurity, the lattice constant is adjusted. It is possible that the lattice constant of the above semiconductor is equal to that of a perfect crystal. The distortion and the dislocation can be reduced in the crystal.

According to another aspect of the present invention, because the compound semiconductor single crystal comprises a Group 13 (3B) element of the periodic table and a Group 15 (5B) element thereof, wherein indium (In) is added as an impurity, it is possible to reduce a crystal defect density thereof and to improve a crystallization thereof.

When each type of semiconductor device, for example, a light emitting diode, a semiconductor laser or the like, which can oscillate a blue light, is manufactured by using a wafer made of the compound semiconductor single crystal according to the present invention, it is expected to improve the yield of the element and the manufacturing efficiency dramatically. It is possible to reduce the manufacturing cost. It can be promoted to reduce the costs of these elements.

## Claims

1. A process for producing compound semiconductor single crystal, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprising the steps of:
(1) introducing a container for growing crystals, in which a predetermined amount of the element M is put and the gas including the element X into a predetermined treatment chamber having a heating member and a pressurizing member;
(2) heating the element M in the container for growing crystals to a predetermined temperature by the heating member to melt the element M;
(3) applying a predetermined pressure to the gas including the element X by the pressurizing member to solve the gas in the melt of the element M; and
(4) further increasing a pressure of the gas including the element X by the pressurizing member while a temperature of the melt of the element M, in which the gas including the element X is solved is kept constant, and controlling the heating member and the pressurizing member so that conditions of a temperature and of a pressure can be in a stable domain as a solid state according to a pressure-temperature constitutional diagram (P-T constitutional diagram) of the compound semiconductor MₘXₙ, to grow the single crystal of the compound semiconductor MₘXₙ.

2. A process for producing compound semiconductor single crystal, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprising the steps of:
(1) introducing a container for growing crystals, in which a predetermined amount of the element M is put and the gas including the element X into a predetermined treatment chamber having a heating member and a pressurizing member;
(2) heating the element M in the container for growing crystals to a predetermined temperature by the heating member to melt the element M;
(3) applying a predetermined pressure to the gas including the element X by the pressurizing member to solve the gas in the melt of the element M; and
(4) decreasing a temperature of the melt of the element M, in which the gas including the element X is solved, and controlling the heating member and the pressurizing member so that a pressure of the gas including the element X can at least exceed an equilibrium vapor pressure in a stable domain as a solid state according to a pressure-temperature constitutional diagram (P-T constitutional diagram) of the compound semiconductor MₘXₙ and preferably at the same time, the pressure of the gas can be kept constant, to grow the single crystal of the compound semiconductor MₘXₙ.

3. A process for producing compound semiconductor single crystal as claimed in claim 1 or 2, wherein when the element M includes an impurity Y, a Z acting as a gettering agent for the impurity Y is disposed in the treatment chamber.

4. A process for producing compound semiconductor single crystal as claimed in any one of claims 1 to 3, wherein the element M is one selected from the group consisting of Zn, Cd and Hg which are the Group 12 (2B) elements of the periodic table.

5. A process for producing compound semiconductor single crystal as claimed in any one of claims 1 to 3, wherein the element M is one selected from the group consisting of Al, Ga and In which are the Group 13 (3B) elements of the periodic table.

6. A process for producing compound semiconductor single crystal as claimed in claim 5, wherein the element X is one selected from the group consisting of N, P and As which are the Group 15 (5B) elements of the periodic table.

7. A process for producing compound semiconductor single crystal as claimed in claim 4, wherein the element X is one selected from the group consisting of S, Se and Te which are the Group 16 (6B) elements of the periodic table.

8. A process for producing compound semiconductor single crystal as claimed in claim 1 or 2, wherein the element M is one selected from the group consisting of Zn, Cd and Hg which are the Group 12 (2B) elements of the periodic table and the element X is O which is the Group 16 (6B) element of the periodic table.

9. A process for producing compound semiconductor single crystal as claimed in any one of claims 1 to 7, wherein the gas including the element X is one selected from the group consisting of N₂ and NH₃.

10. A process for producing compound semiconductor single crystal as claimed in any one of claims 1, 2 and 8, wherein the element M is one selected from the group consisting of Zn, Cd and Hg which are the Group 12 (2B) elements of the periodic table and the gas including the element X is O₂.

11. A process for producing compound semiconductor single crystal as claimed in any one of claims 1, 2, 3, 5 and 6, wherein the compound semiconductor MₘXₙ is one selected from the group consisting of GaN, AlN and InN.

12. A process for producing compound semiconductor single crystal as claimed in any one of claims 1, 2, 3, 4, 8 and 10, wherein the compound semiconductor MₘXₙ is ZnO.

13. A process for producing compound semiconductor single crystal as claimed in any one of claims 3, 4, 5, 6, 7, 9 and 11, wherein the impurity Y described in claim 3 is one selected from the group of H₂O and O.

14. A process for producing compound semiconductor single crystal as claimed in any one of claims 3 to 13, wherein the Z acting as a gettering agent is one selected from the group of Ca, Mg, Li, Al, Ti, Si, V, Mn, Cr, Na, Zn and Fe.

15. A process for producing compound semiconductor single crystal as claimed in any one of claims 1 to 14, wherein as a seed crystal for growing the compound semiconductor MₘXₙ, a single crystal substrate having a melting point which is higher than the growth temperature of the compound semiconductor MₘXₙ crystal to be grown, a different composition from the compound semiconductor MₘXₙ crystal and a low solubility in the melt of the element M is used.

16. A process for producing compound semiconductor single crystal as claimed in claim 15, wherein a plurality of the single crystal substrates are used.

17. A process for producing compound semiconductor single crystal as claimed in claim 15 or 16, wherein the single crystal substrate is a sapphire (aluminum oxide: Al₂O₃) substrate.

18. A process for producing compound semiconductor single crystal as claimed in claim 15, wherein the single crystal substrate is one selected from the group consisting of SiC, MgAl₂O₄, MgO, ZnO, LiAlO₂, LiAlO₂, LiNbO₃, LiTaO₃, YAlO₃, ScAlMgO₄ and LaSrGaO₄.

19. A process for producing compound semiconductor single crystal as claimed in claim 15 or 16, wherein the single crystal substrate is a perovskite crystal substrate.

20. A process for producing compound semiconductor single crystal as claimed in claim 19, wherein the perovskite crystal substrate is composed of one selected from the group consisting of NdGaO₃, LaAlO₃, LaTaO₃, SrAlO₃ and SrTaO₃.

21. A process for producing compound semiconductor single crystal as claimed in claim 15 or 16, wherein the single crystal substrate is an apatite crystal substrate.

22. A process for producing compound semiconductor single crystal as claimed in claim 21, wherein the apatite crystal substrate is a Ca₈La₂(PO₄)₆O₂ substrate.

23. A process for producing compound semiconductor single crystal as claimed in any one of claims 1 to 22, wherein a size of a cluster of the compound semiconductor MₘXₙ is reduced by keeping the melt of the element M at a temperature which is 50°C higher than an equilibrium temperature at which a solubility of the element X in the melt of the element M or that of the gas including the element X therein is a predetermined one, or by keeping at the equilibrium temperature for 12 hours or more.

24. An apparatus for producing compound semiconductor single crystal, to which a process for producing compound semiconductor single crystal as claimed in any one of claims 1 to 23 is applied, in which a single crystal of a compound semiconductor MₘXₙ (where M is a Group 12 (2B) element of the periodic table or a Group 13 (3B) element thereof, X is a Group 15 (5B) element of the periodic table or a Group 16 (6B) element thereof, and m and n are integers which are 1 or more) is produced by solving a gas including an element X in a melt of an element M under a high pressure; comprising:
a treatment chamber formed by a high pressure cylinder;
a container for growing crystals, which is disposed in the treatment chamber and in which a predetermined amount of the element M is put;
a sealing member engaged with an upper position of the treatment chamber;
a gas compressing member for introducing the gas including the element X into the treatment chamber, which is connected with the sealing member;
a heating member for heating the container for growing crystals to a predetermined temperature to melt the element M in the container for growing crystals;
a pressurizing member for increasing a pressure in the treatment chamber to a predetermined pressure to solve the gas including the element X in the melt of the element M;
a controlling member for controlling the heating member and the pressurizing member so that a condition of a temperature of the container for growing crystals and that of a pressure can be in a stable domain as a solid state according to a pressure-temperature constitutional diagram (P-T constitutional diagram) of the compound semiconductor MₘXₙ.

25. An apparatus for producing compound semiconductor single crystal as claimed in claim 24, wherein the container for growing crystal is a crucible made by pBN, the sealing member is an upper plug having a high pressure gas inlet, the gas compressing member is a compressor having a pressure adjuster and a gas feed system, the heating member is a graphite heater, the pressurizing member is a piston having a lifting device, and the controlling member is a control device having a microcomputer.

26. A compound semiconductor single crystal being a single crystal of a compound semiconductor MₘXₙ (where when an element M is a Group 13 (3B) element, an element X is nitrogen, or when an element M is a Group 12 (2B) element, an element X is oxygen, and m and n are integers which are 1 or more),
wherein an element having an ionic radius which is smaller than that of either element between a component element M of the compound semiconductor MₘXₙ and a component element X thereof, or which is approximate to that of either element between the component element M of the compound semiconductor MₘXₙ and the component element X thereof, is added as an impurity, and the single crystal has an ingot form.

27. A compound semiconductor single crystal as claimed in claim 26, wherein the element M is Ga, and the impurity is at least one selected from the consisting of Be, Mg, Zn, B, Al, C, Si and Ge.

28. A compound semiconductor single crystal as claimed in claim 26 or 27, wherein the element X is N, and the impurity is one selected from the group consisting of O and F.

29. A compound semiconductor single crystal as claimed in claim 26, wherein the element M is Zn, and the impurity is at least one selected from the group consisting of Li, Be, B, Al, Ga, C, Si and Ge.

30. A compound semiconductor single crystal as claimed in claim 26 or 29, wherein the element X is O, and the impurity is F.

31. A compound semiconductor single crystal comprising a Group 13 (3B) element of the periodic table and a Group 15 (5B) element thereof, wherein In is added as an impurity and the compound semiconductor single crystal has an ingot form.

32. A compound semiconductor single crystal as claimed in claim 31, wherein the compound semiconductor single crystal to which the In is added is GaN or a compound thereof.

33. A semiconductor device wherein a wafer made of a compound semiconductor single crystal as claimed in any one of claims 26 to 32 is used as a substrate.
